## Europäisches Patentamt
## European Patent Office
## Office européen des brevets

(11) Publication number: **0 135 274**
**A2**

(12) # EUROPEAN PATENT APPLICATION

(21) Application number: **84304701.0**

(22) Date of filing: **10.07.84**

(51) Int. Cl.⁴: **H 03 M 1/80**

(30) Priority: **12.08.83 US 522901**

(43) Date of publication of application:
**27.03.85 Bulletin 85/13**

(84) Designated Contracting States:
**DE FR GB IT NL**

(71) Applicant: **TRW INC.**
**23555 Euclid Avenue**
**Cleveland Ohio 44117(US)**

(72) Inventor: **Packard, Dennis John**
**13121 Silver Saddle Lane**
**Poway California 92064(US)**

(74) Representative: **Allden, Thomas Stanley et al,**
**A.A. THORNTON & CO. Northumberland House 303-306**
**High Holborn**
**London WC1V 7LE(GB)**

(54) **Digital-to-analog converter.**

(57) A digital-to-analog converter well suited for fabrication in monolithic form, in which lower-order bits of the input are converted by means of binary-weighted current switches, and higher-order bits of the input are converted by means of a thermometer-type decoder and current segment switches. Specifically, the converter includes a digital input register, a second register to receive the lower-order bits of the input, a set of binary-weighted current switches to generate an analog signal component proportional to the lower-order bits of the input, a thermometer-type decode to decode the higher-order bits of the input, and a set of identical current segment switches to generate an analog signal component proportional to the higher-order bits of the input. Importantly, there is also a third register between the decoder and the identical current segment switches, to insure that the current-weighted switches and the identical current segment switches are actuated simultaneously to minimize output transients.

./...

Fig. 4

-1-

# DIGITAL-TO-ANALOG CONVERTER

## BACKGROUND OF THE INVENTION

This invention relates generally to analog-to-digital converters, and more particularly, to monolithic devices for digital-to-analog conversion.

A well known problem associated with conventional digital-to-analog circuitry is the presence in the analog output of large switching transients referred to as "glitches." To appreciate how glitches arise, one has only to consider that most digital-to-analog conversion circuitry operates by applying a multi-bit digital input signal to a plurality of switches. Either the switches provide an output current contribution that is weighted in a binary fashion in accordance with the switch position, or the switches carry identical currents, but are connected to a resistance network that provides the necessary binary weighting to generate the analog output signal.

In both types of converter, glitches can arise if the switches are not perfectly matched, or if the digital input is subject to "skewing" or rapid switching of its individual bit stages. The worst possible situation for the generation of switching transients is one in which all of the switches must change state to register a small increment of change in the input signal. For example, in the transition from a binary input of 01111111 to one of 10000000, seven switches must open and an eighth must close simultaneously to avoid a switching glitch.

If current-weighted switches are used, i.e. the switches conduct different currents in accordance with a binary weighting scheme, glitches can arise because the switching speed usually depends on the magnitude of the current that is being switched. For converters providing higher resolution, i.e. a larger number of input bits, the range of current values is correspondingly great. Another problem with current weighting is that resistors, used in a ladder network that provides the current weightings, will not have equal voltages applied across them. This leads to a nonlinear weighting effect referred to as integral nonlinearity.

Another important factor in digital-to-analog converter performance is differential linearity. This term refers to the ideal constancy of the relationship between an increment of digital input and a corresponding increment in the analog output signal. For higher-resolution converters, with larger numbers of switches and larger ladder networks for binary weighting, maintaining good differential linearity becomes increasingly difficult.

All of these difficulties are aggravated in high-speed applications. If there is no need for a rapid analog output, a settling time can be permitted before sampling the output. In high-speed applications demanding high resolution as well, such as in the reconstitution of video signals from their digital equivalents, minimization of output glitches and maintaining good linearity become very important considerations.

It will be appreciated from the foregoing that there is still a great need in the field of digital-to-analog circuitry for a device that has low glitch energy and good linearity, and may be conveniently implemented in monolithic form. The present invention satisfies this need.

## SUMMARY OF THE INVENTION

The present invention resides in a digital-to-analog circuit providing high resolution at high speed, but with relatively low output glitch energy, and good linearity characteristics. Basically, and in general terms, the converter of the invention includes a reference voltage source; a first register having a plurality n of binary stages for holding a binary-coded input quantity; thermometer decoding means for receiving a plurality m of consecutive bits from the most significant end of the first register and producing binary output signals on $2^m-1$ output lines in a thermometer code indicative of the m most significant bits of the input quantity; a second register having a plurality (n-m) of binary stages for holding a set of (n-m) consecutive bits from the least significant end of the first register; and a third register having $2^m-1$ binary stages for holding binary signals output from the thermometer decoding means. In addition, the converter includes a plurality of $2^m-1$ identical current sources coupled to the voltage reference; a plurality of $2^m-1$ current segment switches connected to receive current from the identical current sources, to receive switching signals from the third register, and to conduct current to an analog output terminal; a plurality of (n-m) current sources coupled to the voltage reference to provide a set of binary-weighted currents; and a plurality of (n-m) current-weighted switches connected to receive current from the (n-m) weighted current sources, to receive switching signals from the second register, and to conduct current to the analog output terminal.

In operation, the converter of the invention keeps the output glitch energy relatively low by the use of current segment switches for the most significant bits of the input quantity to be converted. The second and third registers function to equalize the times of switching of the current-weighted switches and the current segment switches. Moreover, if the input data should be subject to skewing, the improved glitch performance of the device will not be significantly affected.

Another advantage of the invention is that use of the thermometer decoding means for the bits of higher significance greatly inproves linearity. Each of the identical current switches contributes exactly the same amount of current to the analog output, equivalent to one increment, or least significant bit, of digital input. Thus, for example, if differential linearity error is to be no greater than one-quarter of the least-significant-bit increment, the identical current sources and related current switches need only be matched to within 25 percent of each other. Integral linearity is also improved because all resistors in the identical current sources have the same voltage applied across them.

It will be appreciated from the foregoing that the invention represents a significant advance. in the field of digital-to-analog converters. In :particular, the converter of the invention provides an output characterized by low glitch energy and good linearity. Although these desirable characteristics are obtained at the expense of increased numbers of components to provide the necessary registers and current switches, the device is well suited for fabrication in monolithic form at reasonable cost. Other aspects and advantages of the invention will become apparent from the following more detailed description, taken in conjunction with the accompanying drawings.

## BRIEF DESCRIPTION OF THE DRAWINGS

FIGURE 1 is a block diagram of a digital-to-analog circuit of the prior art, using identical current sources and a resistive ladder network for binary weighting;

FIG. 2 is a block diagram of another type of digital-to-analog circuit of the prior art, using binary-weighted current sources;

FIG. 3 is a block diagram of an ideal digital-to-analog circuit using a large number of identical current segment switches coupled to a thermometer decoder; and

FIG. 4 is a block diagram of the digital-to-analog circuit of the present invention.

## DESCRIPTION OF THE PREFERRED EMBODIMENT

As shown in the drawings for purposes of illustration, the present invention is concerned with digital-to-analog converters. Ideally, the output of a digital-to-analog converter should be as free from transients or "glitches" as possible, should be able to tolerate skewing of the input signals, and should have good linearity characteristics. Although these are design goals in all digital-to-analog converters, they are most difficult to achieve in high-speed converters providing a high-resolution output.

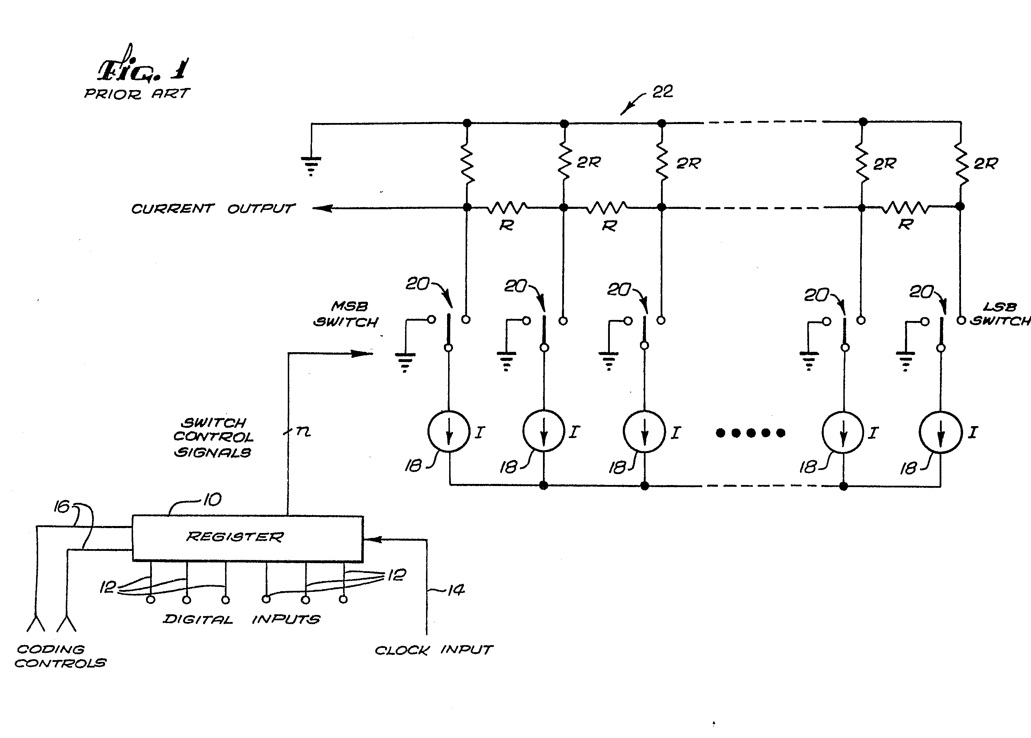

FIG. 1 shows the general principle of a digital-to-analog converter. A binary-coded digital input quantity is clocked into an input register, indicated by reference numeral 10, over input lines 12. A clocking signal on line 14 to the register 10, and other coding control signals on lines 16, control input of the digital quantity. The remainder of the converter circuit includes a plurality of current sources 18 powered by a reference voltage (not shown), an equal plurality of switches 20 connected to respective current sources, and a resistance ladder network 22 connecting the switches to an output line 24. Output signals from the input register 10 are connected over lines 26 to control the positions of the switches 20.

The resistance ladder 22 is of a well known form referred to as an R-2R ladder, since most of its resistive components have resistances R and 2R, where R is a selected resistance value. The R-2R ladder has the property of providing binary weighting to the various current contributions from the respective switches 20. Thus, when the least-significant-bit switch 20 is in an "on" condition to supply current to the ladder 22, it will contribute to the output one half of the current that the next most significant bit switch will contribute. The difficulty with this design is that the switches 20 must operate in precise synchronism if output glitches are to be avoided when there is a major transition, for example from 01111111 to 10000000 in the input quantity.

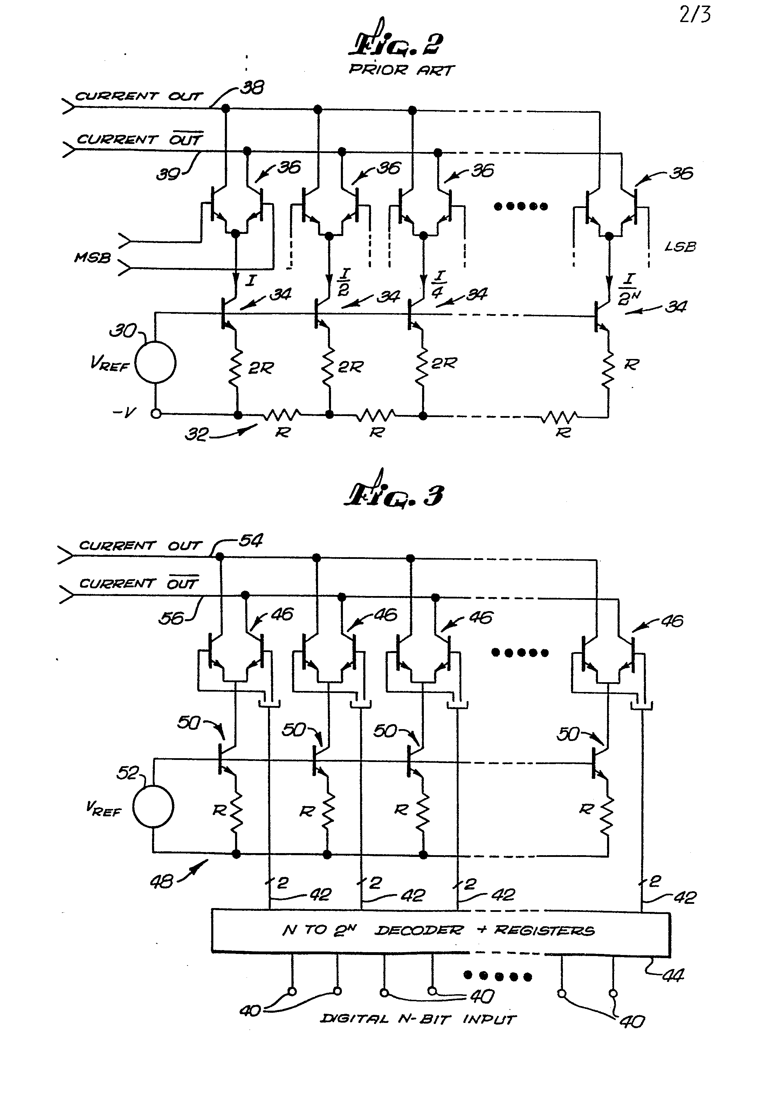

FIG. 2 shows another form of digital-to-analog converter in which the current sources are binary-weighted. The converter comprises a voltage reference 30 connected to a set of weighted current sources, an R-2R resistance ladder 32, and a plurality of bipolar transistors 34. The effect of the ladder 32 is to weight the current surces to provide successive values of I, I/2, I/4, and so forth up to $I/2^n$, where n is the number of binary stages in the converter. The transistors 34 are each connected to the emitters of pairs of additional transistors 36, which function as current switches. The collectors of the pairs of transistors 36 are connected to current output lines 38 and 39, and the bases of the transistors 36 are connected to complementary switching signals derived from the digital input.

When the FIG. 2 configuration is used in high resolution applications, resistors and transistors must be precisely matched in performance over a very wide range of operating currents. For a 12-bit device, for example, the switched currents in one specific design range from as low as 8 microamperes for the least-significant bit to 16.4 milliamperes for the most-significant bit. Furthermore, the resistors in the ladder 32 are subjected to unequal voltages and this results in a non-linear weighting effect.

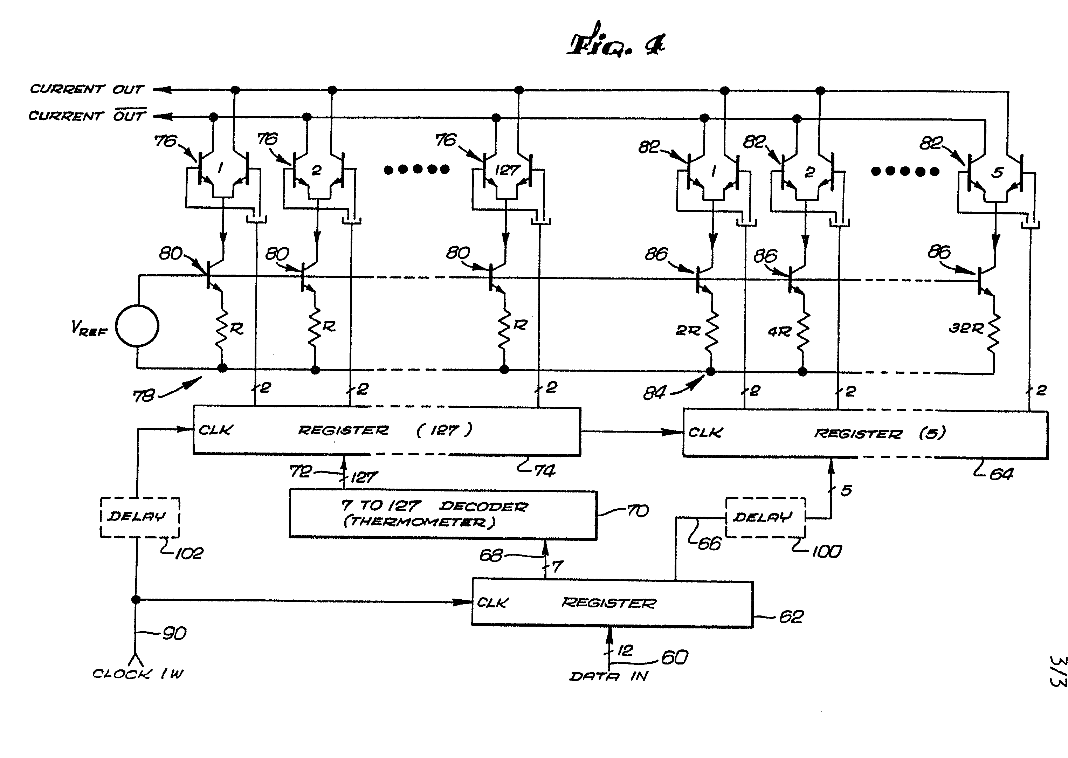

One largely theoretical solution to these problems is to use the configuration of FIG. 3. Instead of providing binary weighting of current sources or binary weighting in a resistance ladder, an n-bit digital input on lines 40 is transformed to a thermometer-type code of $2^n$ bits on lines 42 from a decoder 44. A thermometer code is one in which a consecutive subset of output lines is energized to indicate the value of the binary input. For example, in a 4-bit device a binary input of 0001 would energize just one output line of sixteen: 0000000000000001. A binary input of 1000, or half-scale, would provide an output of 0000000011111111. The term thermometer code is derived from the way that the transition between 1's and 0's in the output moves, like the mercury in a thermometer, to indicate the value of the binary input.

The outputs of the decoder 44 are connected to control a like number of transistor current switches 46, which are supplied with identical currents from a network comprising a resistance ladder 48, transistors 50 and a voltage reference 52. The switches 46 each control an identical current contribution to output lines 54 and 56, the contribution being equivalent to the increment of current provided by a change in the input quantity of one least-significant bit. This circuit has the principal advantage that differential linearity problems are virtually non-existent. Since each switch affects the output magnitude by only the amount of one least-significant bit, errors in matching between the switches introduce only very small linearity errors. For example, a mismatch of 25 percent between switches would result in an error of only one-quarter of a least-significant-bit of input. Since the resistors in the ladder 48 have equal voltages across them, the integral linearity of the circuit is also good. Output glitches are reduced, since the late switching of one of the switches affects the analog output by only one least-significant-bit increment.

From a practical standpoint, however, the FIG. 3 design is not a good one. A 12-bit converter, for example, would require 4,096 switches and a corresponding number of related components. Although matching these components is not a problem, their sheer numbers render the circuit too complex to be economically competitive.

In accordance with the invention, the principal features of the circuits of FIGS. 2 and 3 are combined, and an additional feature is incorporated. Specifically, as shown in FIG. 4, input data is input over lines 60 to an input register 62. At this point, some of the input data is transmitted to a second register 64, over lines 66, and the remainder is transmitted over lines 68 to a thermometer decoder 70. In the example illustrated, a 12-bit input quantity is gated into the input register 60; then the five least significant bits are gated to the second register 64, while the seven most significant bits are transmitted to the decoder 70.

The decoder 70 produces a thermometer code output on $2^7$ or 127 output lines 72, which are connected to a 127-bit register 74. The outputs of the register 74 are coupled to control identical current switches 76, which are supplied with current from a resistive network 78, through transistors 80, in the manner of the circuit of FIG. 3. In the embodiment illustrated, each of the switches 76 contributes a current of 256 microamperes to the output of the device.

The outputs of the second register 64 are connected to control five current-weighted switches 82 supplied with current from a resistive ladder 84 through transistors 86. Both ladder networks 78 and 84 are supplied from a common voltage reference. The currents contributed through the switches 82 are binary-weighted to have values of 128, 64, 32, 16, and 8 microamperes, respectively.

The circuit of the invention operates in such a manner as to produce only relatively low-energy output glitches, because the seven most significant bits are converted to analog form using the thermometer decoder 70 and the current segment switches 76. The register 74 located at the decoder outputs insures that any sudden skewing of the input signal is not propagated through to the analog output, and operation of the identical switches 76 can be matched to a close degree. In any event, a failure of one of the switches to close on time has an effect of only one increment at the least-significant bit position of the seven bits converted. Glitches arising in the switches 82 will also be limited because of the switches' association with the five least-significant bits of the input quantity.

The registers 64 and 74 perform a time-equalizing function in insuring that the two sets of switches 76 and 82 will be actuated simultaneously. A clocking signal on line 90 is used both to clock digital inputs into the input register 62, and to clock the registers 64 and 74 simultaneously. Without the registers 64 and 74, there would be a disparity between the switching times of the two groups of switches 76 and 82.

In accordance with another aspect of the invention, a time delay circuit 100 can be inserted in the input lines 66 to register 64, and another delay circuit 102 inserted in the clock signal line 90 to the registers 74 and 64. If the delay circuits 100 and 102 are appropriately selected to match the delay in the decoder 70, the input register 62 can be eliminated from the circuit.

Another way of defining the glitch performance of the converter is to consider that the five lower-order bits and the seven higher-order bits in the converter are effectively equivalent to a six-bit converter from the standpoint of generation of transients. Glitches of the magnitude generated in a six-bit converter are small enough to be tolerated in a converter providing twelve bits of precision. For good differential linearity in the circuit of the invention, transistor and resistor devices need be matched only to within abount one percent, a figure that is easily attainable using conventional fabrication techniques.

It will be appreciated from the foregoing that the present invention represents a significant advance in the field of digital-to-analog converters. In particular, the invention provides a high-speed, high-resolution converter that is well suited for fabrication as a monolithic device, and has very low output glitch energy and good linearity characteristics. It will also be appreciated that, although a specific embodiment of the invention has been described in detail by way of illus-

-11-

tration, various modifications may be made without departing from the spirit and scope of the invention. Accordingly, the invention is not to be limited except as by the appended claims.

CLAIMS:

1. A digital-to-analog converter, comprising:

a reference voltage source;

a first register having a plurality n of binary stages for holding a binary-coded input quantity;

thermometer decoding means for receiving a plurality m of consecutive bits from the most significant end of said first register and producing binary output signals on $2^m-1$ output lines in a thermometer code indicative of the m most significant bits of the input quantity;

a second register having a plurality (n-m) of binary stages for holding a set of (n-m) consecutive bits from the least significant end of said first register;

a third register having $2^m-1$ binary stages for holding binary signals output from said thermometer decoding means;

a plurality of $2^m-1$ identical current sources coupled to said voltage reference;

a plurality of $2^m-1$ current segment switches connected to receive current from said identical current sources, to receive switching signals from said third register, and to conduct current to an analog output terminal;

a plurality of (n-m) current sources coupled to said voltage reference to provide binary weighting; and

a plurality of (n-m) current-weighted switches connected to receive current from said (n-m) weighted current sources, to receive switching signals from said second register, and to conduct current to said analog output terminal;

whereby the converter of the invention keeps output glitch energy low by the use of current segment switches for the most significant bits of the input quantity to be converted.

2. A digital-to-analog converter as set forth in claim 1, wherein:
said second and third registers are clocked together to provide control signals to said current segment switches and said current-weighted switches simultaneously.

3. A digital-to-analog converter as set forth in claim 1, wherein:
said current segment switches include pairs of complementary transistors switchable by complementary signals from said decoder; and
said current-weighted switches include pairs of complementary transistors switchable by complementary signals from said second register.

4. A digital-to-analog converter as set forth in claim 3, wherein:
said identical current sources include a plurality $2^m-1$ of transistors and an equal plurality of identical resistors connected in a network.

5. A digital-to-analog converter as set forth in claim 3, wherein:
said binary-weighted current sources include a plurality (n-m) of transistors and an equal plurality of resistors of binarily increasing values connected in a network.

6. A digital-to-analog converter, comprising:
a reference voltage source;
thermometer decoding means for receiving a plurality m of consecutive and most significant bits from a plurality n of binary input signals, and producing binary output signals on $2^m-1$ output lines in a thermometer code indicative of the m most significant bits of the input quantity;

a first register having a plurality (n-m) of binary stages for holding a set of (n-m) consecutive and least significant bits of the binary input signal;

a second register having $2^m-1$ binary stages for holding binary signals output from said thermometer decoding means;

a plurality of $2^m-1$ identical current sources coupled to said voltage reference;

a plurality of $2^m-1$ current segment switches connected to receive current from said identical current sources, to receive switching signals from said second register, and to conduct current to an analog output terminal;

a plurality of (n-m) current sources coupled to said voltage reference to provide binary weighting; and

a plurality of (n-m) current-weighted switches connected to receive current from said (n-m) weighted current sources, to receive switching signals from said first register, and to conduct current to said analog output terminal;

whereby the converter of the invention keeps output glitch energy low by the use of current segment switches for the most significant bits of the input quantity to be converted.

7. A digit-to-analog converter as set forth in claim 6, and further including:

time delay means coupled to the input to said first register, to provide a time delay matching that of said thermometer decoding means.

Fig. 1
PRIOR ART

## Fig.2
### PRIOR ART

CURRENT OUT — 38

CURRENT $\overline{OUT}$

39 — 36 — 36 — 36 — 36

MSB

LSB

$I$ — 34 — $\frac{I}{2}$ — 34 — $\frac{I}{4}$ — 34 — $\frac{I}{2^N}$ — 34

30 — $V_{REF}$ — 34

$-V$ — 2R — 2R — 2R — R

32 — R — R — R

## Fig.3

CURRENT OUT — 54

CURRENT $\overline{OUT}$

56 — 46 — 46 — 46 — 46

50 — 50 — 50 — 50

52 — $V_{REF}$

R — R — R — R

48

2 — 42 — 2 — 42 — 2 — 42 — 2 — 42

N TO $2^N$ DECODER + REGISTERS

44

40 — 40 — 40

DIGITAL N-BIT INPUT

Fig. 4